(19) Europäisches Patentamt
European Patent Office
Office européen des brevets

(11) **EP 3 692 680 B1**

(12) **EUROPÄISCHE PATENTSCHRIFT**

(45) Veröffentlichungstag und Bekanntmachung des Hinweises auf die Patenterteilung:
**14.02.2024  Patentblatt 2024/07**

(21) Anmeldenummer: **18773980.0**

(22) Anmeldetag: **19.09.2018**

(51) Internationale Patentklassifikation (IPC):
**H04L 7/08** (2006.01)  **G01D 5/244** (2006.01)
**H03K 5/19** (2006.01)  **H04Q 9/00** (2006.01)
**G01R 29/027** (2006.01)  **B60R 21/01** (2006.01)
**H03K 5/26** (2006.01)

(52) Gemeinsame Patentklassifikation (CPC):
**H04L 7/08; G08C 25/00; H03K 5/19; H03K 5/26; H04Q 9/00; H04Q 9/04;** H04L 7/0012; H04Q 2209/30

(86) Internationale Anmeldenummer:
**PCT/EP2018/075275**

(87) Internationale Veröffentlichungsnummer:
**WO 2019/068460 (11.04.2019 Gazette 2019/15)**

(54) **VORRICHTUNG UND VERFAHREN ZUR KORREKTUR VON MINDESTENS EINEM ÜBERTRAGUNGSPARAMETER EINES SENSORS**

DEVICE AND METHOD FOR CORRECTING A TRANSMISSION PARAMETER OF A SENSOR

DISPOSITIF ET PROCÉDÉ DE CORRECTION D'UN PARAMÈTRE DE TRANSMISSION D'UN CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.10.2017  DE 102017217723**

(43) Veröffentlichungstag der Anmeldung:
**12.08.2020  Patentblatt 2020/33**

(73) Patentinhaber: **Robert Bosch GmbH**
**70442 Stuttgart (DE)**

(72) Erfinder:
• **WALZ, Michel**
**72800 Eningen (DE)**
• **SCHOU, Frank**
**71254 Ditzingen (DE)**
• **CONRADT, Joerg**
**70806 Kornwestheim (DE)**
• **EWERT, Marlon Ramon**
**74199 Untergruppenbach (DE)**
• **GSCHWIND-SCHILLING, Rainer**
**71277 Rutesheim (DE)**
• **AJANOVIC, Mustafa**
**71067 Sindelfingen (DE)**
• **HAIST, Kevin**
**71254 Ditzingen (DE)**
• **HAUG, Michael**
**70499 Stuttgart (DE)**
• **WEISS, Guenter**
**74399 Walheim (DE)**
• **BOMMER, Daniela**
**71229 Leonberg (Warmbronn) (DE)**
• **ROZIC, Darko**
**72762 Reutlingen (DE)**

(56) Entgegenhaltungen:
**EP-A2- 0 306 059          WO-A1-2013/083560**
**DE-A1-102012 203 664     US-A1- 2007 177 532**

• **NGUYEN THANG ET AL: "Verification methodology of sophisticated automotive sensor interfaces integrated in modern system-on-chip airbag system", IECON 2013 - 39TH ANNUAL CONFERENCE OF THE IEEE INDUSTRIAL ELECTRONICS SOCIETY, IEEE, 10. November 2013 (2013-11-10), Seiten 2335-2340, XP032539722, ISSN: 1553-572X, DOI: 10.1109/IECON.2013.6699495 [gefunden am 2013-12-30]**

- **Bosch et al.: "Peripheral Sensor Interface Technical Specification V2.1", , 1. Januar 2012 (2012-01-01), Seiten 1-59, XP055197813, Gefunden im Internet: URL:http://psi5.org/fileadmin/user_upload/ 01_psi5.org/04_Specification/Specification s_PDFs/psi5_spec_v2d1_base.pdf[gefunden am 2015-06-23]**

**Beschreibung**

Die Erfindung geht aus von einem Verfahren zur Korrektur von mindestens einem Übertragungsparameter für eine Datenübertragung zwischen einer Sensoreinheit und einem Steuergerät nach der Gattung des unabhängigen Patentanspruchs 1. Gegenstand der vorliegenden Erfindung ist auch eine Vorrichtung zur Durchführung eines solchen Verfahrens.

Peripheral Sensor Interface 5 (PSI5) ist ein offener Standard. Aufbauend auf dem bisherigen PAS4 Protokoll unterstützt der PSI5 Standard Applikationen, in denen bis zu vier Sensoren pro Busknoten in unterschiedlichen Konfigurationen von einem Steuergerät abgefragt werden können. Auch eine bidirektionale Kommunikation zur Sensorkonfigurierung und Diagnose ist vorgesehen.

In Airbag-Systemen werden beispielsweise Daten von Druck- oder Beschleunigungssensoren über strommodulierte Zweidraht-Busse ausgewertet, die über ein Manchester codiertes Protokoll mit dem Steuergerät kommunizieren. Im PSI5 Standard sind auch mögliche Betriebsarten festgelegt. Diese unterscheiden sich zunächst in synchrone und asynchrone Betriebsmodi. Bei den synchronen Betriebsmodi ergeben sich je nach Verschaltung der Sensoren mit der Steuereinheit die drei Betriebsarten: Parallel BUS Mode, in dem die Sensoren parallel geschaltet sind, Universal BUS Mode, in dem die Sensoren seriell verschaltet sind, und Daisy Chain BUS Mode. Kombiniert mit anderen Parametern, wie gesamte Anzahl der Zeitschlitze, Datenrate, Datenwortlänge, Parity-/CRC Überwachung, erlaubt der PSI5 Standard unterschiedliche Realisierungsmöglichkeiten. Weit verbreitet ist die Verwendung einer 10-Bit Datenwortlänge.

Aufgrund von Oszillatortakttoleranzen auf einem Sensor ist die Anzahl an Bits, welche innerhalb eines PSI5 Kommunikationsmodus übertragen werden können begrenzt. Beispielsweise können 10Bit Sensordaten innerhalb eines 125k Kommunikationsmodus in drei unterschiedlichen Kommunikationsslots übertragen werden, auch wenn der Oszillatortakt des Sensors über seine Lebensdauer um $\pm 5\%$ abweichen kann. Jedoch ist es bei bekannten Verfahren nicht möglich, innerhalb von vier Kommunikationsslots im 16Bit Modus bei 189k mit drei Busteilnehmern bei einer Oszillatorabweichung von $\pm 5\%$ zu kommunizieren, da es sonst zu Datenkollisionen auf dem Bus kommen kann.

Aus der EP 0 306 059 A2 ist ein Telemetriesystem zum Erfassen von entfernten physikalischen Ereignissen und zum Übertragen und Verstärken eines digitalen Datensignals bekannt, welches die erfassten Ereignisse auf einer Übertragungsleitung repräsentiert. Das Telemetriesystem umfasst einen Haupttakt und eine Vielzahl von Messstationen zum Erfassen von lokalen Daten. Die Messstationen legen lokale Daten als digitales Datensignal auf die Übertragungsleitung, und eine Steuereinheit bzw. Empfänger empfängt die digitalen Daten. Der Haupttakt initialisiert das System-Timing und erzeugt ein Sync-Signal. Jede Messstation enthält ein Verstärkeruntersystem zum Empfangen der lokalen digitalen Daten und zum Injizieren der digitalen Daten auf die Übertragungsleitung als digitales Datensignal. Während des Systemstarts beansprucht jedes Verstärkeruntersystem basierend auf einem Organisationsprozess einen Zeitschlitz zum Injizieren des digitalen Datensignals auf die Übertragungsleitung. Das Verstärkeruntersystem der einzelnen Messstationen enthält ferner eine Verstärkungsschaltung zum Verstärken der digitalen Datensignale, welche sich auf der Übertragungsleitung ausbreiten, sowie des Synchronisationssignals. Die Verstärkerschaltung umfasst eine bistabile Vorrichtung mit negativer Impedanz, um die Amplitude und Anstiegszeit des digitalen Datensignals zu verbessern. Jedes Verstärkeruntersystem enthält ferner eine Schaltmodusregelschaltung zum Übertragen eines Versorgungsstroms über die Übertragungsleitung als Spannungspegel, wodurch die Komponenten der lokalen Messstationen mit Energie versorgt werden.

Aus der US 2011/0026572 sind eine Vorrichtung und ein Verfahren zur Erkennung von Baudratenfehlern bekannt, welche einen Flankendetektor, eine StartbitAbtastschaltung und eine Erkennungsschaltung für abnormale Wellenformen aufweist. Der Flankendetektor empfängt ein "Sync-Field", welches Referenztaktsignale enthält und zum Einstellen einer Baudrate einer seriellen Kommunikation verwendet wird, und erzeugt ein Flankenerfassungssignal als Reaktion auf eine in dem "Sync-Field" enthaltene Flanke. Die Startbitabtastschaltung misst eine Bitbreite eines Startbits des "Sync-Field" basierend auf dem Flankenerfassungssignal und einem internen Taktsignal und erzeugt ein Signal mit einem erwarteten Wert, welches die Bitbreite des Startbits als einen erwarteten Wert angibt. Die Erkennungsschaltung für eine abnormale Wellenform misst eine Zwischenflankenbreite nach dem Startbit auf der Grundlage des Flankenerfassungssignals und des internen Taktsignals und erzeugt ein Erkennungssignal für eine abnormale Wellenform, wenn ein Fehler zwischen der Zwischenflankenbreite und dem erwarteten Wert vorliegt. Das Erkennungssignal zeigt an, dass der erwartete Wert einen vorbestimmten zulässigen Fehlerbereich überschreitet.

Aus der DE 10 2012 203 664 A1 ist ein Verfahren zur Nachführung eines Frequenzsignals sowie eine zugehörige Sensoreinheit für ein Fahrzeug bekannt. Das Frequenzsignal wird innerhalb einer Sensoreinheit mit einer vorgegebenen Periodendauer erzeugt und bereitgestellt. Über mindestens eine Schnittstelleneinheit wird mindestens ein Referenzsignal empfangen, wobei das bereitgestellte Frequenzsignal von einem ersten Zähler innerhalb der Sensoreinheit gezählt wird. Hierbei wird ein aktueller Zählerstand des ersten Zählers in Abhängigkeit des mindestens einen Referenzsignals in einem ersten Register innerhalb der Sensoreinheit gespeichert und von einer Vergleichseinheit innerhalb der Einheit mit einem vorgegebenen Wertebereich verglichen, welcher in Abhängigkeit von mindestens einem vorgegebenen Schwellwert definiert wird. Von der Vergleichseinheit wird ein Einstellsignal erzeugt, welches ein Nachführen der Frequenz des Frequenzsignals bewirkt, wenn der vom ersten Register als Ausgabesignal ausgegebene aktuelle Zählerstand des ersten Zählers außerhalb des vorgegebenen Wertebereichs liegt, wobei über das Einstellsignal ein Nachführsignal für das Frequenzsignal erzeugt wird. Hierbei kann ein erstes Einstellsignal erzeugt werden, welches über das Nachführsignal eine Erhöhung der Frequenz des Frequenzsignals bewirkt, wenn die aktuelle Frequenz des bereitgestellten Frequenzsignals zu niedrig ist. Alternativ kann ein zweites Einstellsignal erzeugt werden, welches über das Nachführsignal eine Absenkung der Frequenz des Frequenzsignals bewirkt, wenn die aktuelle Frequenz des bereitgestellten Frequenzsignals zu hoch ist.

Offenbarung der Erfindung

Das Verfahren zur Korrektur von mindestens einem Übertragungsparameter für eine Datenübertragung zwischen einer Sensoreinheit und einem Steuergerät mit den Merkmalen des unabhängigen Patentanspruchs 1 und die Vorrichtung zur Korrektur von mindestens einem Übertragungsparameter für eine Datenübertragung zwischen einer Sensoreinheit und einem Steuergerät mit den Merkmalen des unabhängigen Patentanspruchs 3 haben jeweils den Vorteil, dass durch Korrektur von mindestens einem Übertragungsparameter eine Übertragung mit dem PSI5 Standard in beliebigen Kommunikationsmodi über die Lebensdauer des Fahrzeugs fehlerfrei ermöglicht werden kann, auch wenn der Sensoroszillatortakt über die Lebensdauer des Fahrzeugs abweichen kann. Somit ermöglichen Ausführungsformen der vorliegenden Erfindung eine einwandfreie Datenübertragung über den PSI5 Standard auch dann, wenn der Oszillatortakt der Sensoreinheit in einem gewissen Rahmen gestört ist und bestimmte zeitlich sehr enge PSI5 Kommunikationsmodi realisiert werden sollen. Dadurch kann in vorteilhafter Weise die Sicherheit im Straßenverkehr erhöht werden, da Sensoreinheiten mit einem defekten Sensoroszillator in einem bestimmten Bereich trotzdem noch Daten übertragen können. Dadurch können Fehlnichtauslösungen minimiert werden.

Ausführungsformen der vorliegenden Erfindung stellen ein Verfahren zur Korrektur von mindestens einem Übertragungsparameter für eine Datenübertragung zwischen einer Sensoreinheit und einem Steuergerät zur Verfügung. Von einem Sensoroszillator wird ein Sensortaktsignal mit einer vorgegebenen Periodendauer erzeugt, wobei der mindestens eine Übertragungsparameter basierend auf dem Sensortaktsignal bestimmt wird. Zudem wird ein von einem Referenzoszillator mit einer vorgegebenen Referenzperiodendauer erzeugtes Referenztaktsignal empfangen. Hierbei wird das Sensortaktsignal mit dem Referenztaktsignal verglichen, wobei basierend auf dem Vergleich eine Abweichung der aktuellen Periodendauer des Sensortaktsignals von einer Sollperiodendauer ermittelt wird, und wobei der mindestens eine Übertragungsparameter basierend auf der ermittelten Abweichung korrigiert wird. Hierbei wird in Abhängigkeit von der Abweichung ein Korrekturfaktor berechnet, welcher auf den mindestens einen Übertragungsparameter angewendet wird. Der mindestens eine Übertragungsparameter wird in einstellbaren Stufen an die ermittelte Abweichung angepasst. Dadurch erfolgt die Anpassung des mindestens einen Übertragungsparameters, welcher beispielsweise eine Sendestartzeit und/oder eine Bitbreite repräsentieren kann, nicht schlagartig, sondern mit Hilfe eines langsamen Reglers. Ein solcher langsamer Regler bietet den Vorteil, dass die Anpassung der Übertragungsparameter langsam und nicht sprungartig erfolgt. Die Datenübertragung wird somit stabiler. Die Anpassung der Übertragungsparameter erfolgt mit Hilfe des Korrekturfaktors. Der Korrekturfaktor wird um eine eingestellte Stufe reduziert, wenn die Abweichung größer als ein vorgegebener Schwellwert ist. Zudem wird der Korrekturfaktor um die eingestellte Stufe erhöht, wenn die Abweichung kleiner als der vorgegebene Schwellwert ist. Des Weiteren wird der Korrekturfaktor konstant bleiben, wenn die Abweichung gleich dem vorgegebenen Schwellwert ist. Als Schwellwert kann beispielsweise der Wert 0 vorgegeben werden.

Zudem wird eine Vorrichtung zur Korrektur von mindestens einem Übertragungsparameter für eine Datenübertragung zwischen einer Sensoreinheit und einem Steuergerät vorgeschlagen. Ein Sensoroszillator erzeugt und gibt ein Sensortaktsignal mit einer vorgegebenen Periodendauer aus, wobei der mindestens eine Übertragungsparameter basierend auf dem Sensortaktsignal bestimmt wird. Ein Referenzoszillator erzeugt und gibt ein Referenztaktsignal mit einer vorgegebenen Referenzperiodendauer aus. Hierbei umfasst die Vorrichtung zur Korrektur von mindestens einem Übertragungsparameter einen Oszillatormonitor, welcher das Sensortaktsignal und das Referenztaktsignal empfängt und das Verfahren zur Korrektur von mindestens einem Übertragungsparameter ausführt.

Unter der Vorrichtung zur Korrektur von mindestens einem Übertragungsparameter für eine Datenübertragung zwischen einer Sensoreinheit und einem Steuergerät kann vorliegend eine in der Sensoreinheit angeordnete Auswerte- und Steuereinheit verstanden werden, welche erfasste Sensorsignale verarbeitet bzw. auswertet. Die Auswerte- und Steuereinheit kann mindestens eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Auswerte- und Steuereinheit, wie beispielsweise die Funktion des Oszillatormonitors beinhaltet. Es ist jedoch auch möglich, dass der Oszillatormonitor und/oder die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind. Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung der Auswertung verwendet wird, wenn das Programm von der Auswerte- und Steuereinheit ausgeführt wird.

Unter einer Sensoreinheit wird vorliegend eine Baueinheit verstanden, welche mindestens ein Sensorelement umfasst, welches eine physikalische Größe bzw. eine Änderung einer physikalischen Größe direkt oder indirekt erfasst und vorzugsweise in ein elektrisches Sensorsignal umwandelt. So kann die Sensoreinheit beispielsweise als Beschleunigungssensor oder als Drucksensor oder als Drehratensensor mit entsprechenden Sensorelementen ausgeführt werden. Die Sensoreinheit kann beispielsweise zur Detektion von Fußgängerunfällen in einem Fahrzeugstoßfänger verbaut werden. Für die Erkennung von Seitencrashes kann die Sensoreinheit bei einer Ausführung als Beschleunigungssensor an der B-, C- oder D- Säule des Fahrzeugs oder bei einer Ausführung als Drucksensor in der Fahrzeugtür verbaut werden. Für die Erkennung von Frontcrashs kann die Sensoreinheit als Beschleunigungssensor in einem Zentralsteuergerät oder entlang eines Biegequerträgers des Fahrzeugs verbaut werden. Für die Erkennung von Überschlägen bzw. Schleudern kann die Sensoreinheit als Drehratensensor im Zentralsteuergerät oder in einem separaten Gehäuse auf einem Fahrzeugmitteltunnel verbaut werden. Die von Sensoreinheiten ausgegebenen Signale werden von Algorithmen innerhalb des Steuergeräts weiterverarbeitet. Erkennt ein solcher Algorithmus, dass ein Fußgängeraufprall, ein Seitencrash, ein Frontcrash oder ein Überschlag stattgefunden hat, so wird in Abhängigkeit des erkannten Unfallszenarios eine Auslöseentscheidung für aktive Rückhaltemittel (z.B. Airbag) im Fahrzeug getroffen und diese Rückhaltemittel aktiviert, um bei einem Fußgängeraufprall den Fußgänger bzw. bei einem Crashfall die Fahrzeuginsassen zu schützen.

Durch die in den abhängigen Ansprüchen aufgeführten Maßnahmen und Weiterbildungen sind vorteilhafte Verbesserungen des im unabhängigen Patentanspruch 1 angegebenen Verfahrens zur Korrektur von mindestens einem Übertragungsparameter für eine Datenübertragung zwischen einer Sensoreinheit und einem Steuergerät und der im unabhängigen Patentanspruch 3 angegebenen Vorrichtung zur Korrektur von mindestens einem Übertragungsparameter für eine Datenübertragung zwischen einer Sensoreinheit und einem Steuergerät möglich.

In vorteilhafter Ausgestaltung kann die erfindungsgemäße Vorrichtung einen Zähler umfassen, welcher Pulse des Sensortaktsignals zählt. Hierbei kann der Oszillatormonitor den Zähler an einem Startzeitpunkt starten, an welchem der Oszillatormonitor einen ersten Synchronisationspuls des Referenztaktsignals empfängt, und den Zähler an einem Stoppzeitpunkt anhalten, an welchem der Oszillatormonitor einen nachfolgenden zweiten Synchronisationspuls empfängt. Der Einsatz des Zählers ermöglicht eine besonders einfache und kostengünstige Implementierung der erfindungsgemäßen Vorrichtung zur Korrektur von mindestens einem Übertragungsparameter. So kann der Oszillatormonitor einen Zählerstand des Zählers auslesen und mit einem Sollzählerstand vergleichen, welcher aus dem Verhältnis von Referenzperiodendauer zu Sollperiodendauer des Sensortaktsignals berechnet ist. Der Sollzählerstand kann beispielsweise vom Oszillatormonitor oder vorab berechnet und in einem nichtflüchtigen Speicher in der Sensoreinheit gespeichert werden. Basierend auf dem Vergleich kann der Oszillatormonitor eine Abweichung der aktuellen Periodendauer des Sensortaktsignals von einer Sollperiodendauer ermitteln.

In weiterer vorteilhafter Ausgestaltung der erfindungsgemäßen Vorrichtung kann der Oszillatormonitor basierend auf einem vorgegebenen Toleranzbereich für die Abweichung ein Akzeptanzfenster berechnen, welches nach unten durch einen ersten Zählerstand und nach oben durch einen zweiten Zählerstand begrenzt werden kann. Die typischen Toleranzen des Sensortaktsignals liegen über Lebensdauer bei ca. ± 3,5 %. Eine obere Grenze für Oszillatortaktabweichungen in den einzelnen Sensoreinheiten liegt gemäß PSI5 Standard derzeit bei ± 5 %. Die Toleranz des Referenztaktsignals liegt bei ± 1 %. Das Akzeptanzfenster kann somit mit einem zusätzlichen Sicherheitsabstand vorgegeben werden. So kann das Akzeptanzfenster beispielsweise mit einer äußeren Grenze von ± 10 % vorgegeben werden. Die äußere Grenze des beispielhaften Akzeptanzfensters ergibt sich aus der Toleranz des Sensoroszillators von ± 5 %, der Toleranz des Referenztaktsignals von ± 1 % und dem Sicherheitsabstand, der beispielhaft einen Wert von ± 4 % aufweist. Der Sicherheitsabstand wird so gewählt, dass eine Übertragung von Daten in einen Auslösealgorithmus von Rückhaltesystemen zu keiner nennenswerten Abweichung von Auslösezeiten führt.

In weiterer vorteilhafter Ausgestaltung der erfindungsgemäßen Vorrichtung kann der Oszillatormonitor den Korrekturfaktor an die ermittelte Abweichung anpassen und den mindestens einen Übertragungsparameter mit dem angepassten Korrekturfaktor korrigieren, wenn der ausgelesene aktuelle Zählerstand innerhalb des Akzeptanzfensters liegt. Außerdem kann der Oszillatormonitor den zweiten Synchronisationspuls als neuen ersten Synchronisationspuls interpretieren und den Zähler neu starten, wenn der ausgelesene aktuelle Zählerstand innerhalb des Akzeptanzfensters liegt. Zudem kann der Oszillatormonitor den zweiten Synchronisationspuls als Störimpuls interpretieren, wenn der korrespondierende ausgelesene aktuelle Zählerstand kleiner als der erste Zählerstand ist. In diesem Fall kann der Oszillatormonitor den als Störimpuls interpretierten zweiten Synchronisationspuls ignorieren und keine Anpassung des Korrekturfaktors und keine Korrektur des mindestens einen Übertragungsparameters durchführen. Des Weiteren kann der Oszillatormonitor den zweiten Synchronisationspuls als neuen ersten Synchronisationspuls interpretieren, wenn der korrespondierende ausgelesene aktuelle Zählerstand größer als der zweite Zählerstand ist. In diesem Fall kann der Oszillatormonitor in Reaktion auf den als neuer erster Synchronisationspuls interpretierten zweiten Synchronisationspuls den Zähler neu starten und eine Korrektur des mindestens einen Übertragungsparameters mit einem bereits vorhandenen Korrekturfaktor durchführen. Dadurch wird die Datenübertragung bei Ausführungsformen der vorliegenden Erfindung in vorteilhafter Weise noch robuster gegenüber EMV Störungen von außen, welche künstliche oder fehlende Synchronisationspulse bewirken können. Zudem kann dadurch in vorteilhafter Weise verhindert werden, dass eine EMV-Störung zu einer Änderung des Korrekturfaktors führen kann.

Ein Ausführungsbeispiel der Erfindung ist in der Zeichnung dargestellt und wird in der nachfolgenden Beschreibung näher erläutert. In der Zeichnung bezeichnen gleiche Bezugszeichen Komponenten bzw. Elemente, die gleiche bzw. analoge Funktionen ausführen.

Kurze Beschreibung der Zeichnungen

Fig. 1 zeigt ein schematisches Blockdiagramm einer Sensoranordnung in einem Fahrzeug.

Fig. 2 zeigt ein schematisches Blockdiagramm einer Sensoreinheit der Sensoranordnung aus Fig. 1 mit einem Ausführungsbeispiel einer erfindungsgemäßen Vorrichtung zur Korrektur von mindestens einem Übertragungsparameter für eine Datenübertragung zwischen einer Sensoreinheit und einem Steuergerät.

Fig. 3 zeigt eine schematische Darstellung eines ersten Zeitstrahls für ein erfindungsgemäßes Verfahren zur Korrektur von mindestens einem Übertragungsparameter, wobei ein zweiter Synchronisationspuls innerhalb eines Akzeptanzfensters empfangen wird.

Fig. 4 zeigt eine schematische Darstellung eines zweiten Zeitstrahls für das erfindungsgemäße Verfahren zur Korrektur von mindestens einem Übertragungsparameter, wobei der zweite Synchronisationspuls vor dem Akzeptanzfenster empfangen wird.

Fig. 5 zeigt eine schematische Darstellung eines dritten Zeitstrahls für das erfindungsgemäße Verfahren zur Korrektur von mindestens einem Übertragungsparameter, wobei der zweite Synchronisationspuls nach dem Akzeptanzfenster empfangen wird.

Ausführungsformen der Erfindung

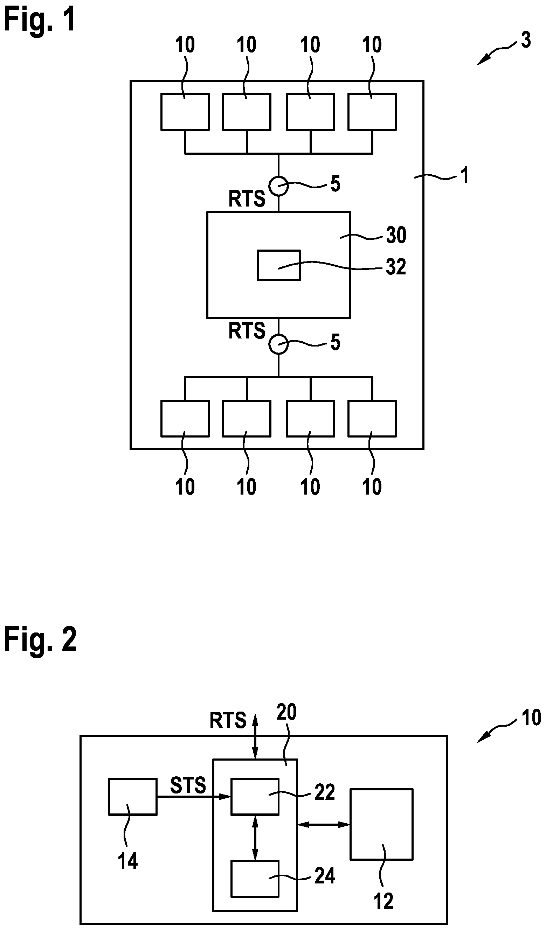

Wie aus Fig. 1 und 2 ersichtlich ist, umfasst eine Sensoranordnung 3 für ein Fahrzeug 1 im dargestellten Ausführungsbeispiel ein Steuergerät 30 mit einem Referenzoszillator 32, welcher ein Referenztaktsignal RTS mit einer vorgegebenen Referenzperiodendauer $T\_ref$ erzeugt und ausgibt, mehrere Busknoten 5, von denen zwei Busknoten 5 dargestellt sind und mehrere Sensoreinheiten 10, welche jeweils als periphere Airbagsensoren ausgeführt und mit einem der Busknoten 5 verbunden sind. Im dargestellten Ausführungsbeispiel sind jeweils vier Sensoreinheiten 10 mit einem der Busknoten 5 verbunden. In der dargestellten Sensoranordnung 3, welche Teil eines Personenschutzsystems des Fahrzeugs 1 ist, sind die einzelnen Sensoreinheiten 10, Busknoten 5 und das Steuergerät 30 über strommodulierte Zweidrahtbusse miteinander verbunden und kommunizieren über den PSI5 Standard. Dadurch kann das Steuergerät 30 die von den Sensoreinheiten 10 erfassten Druck- oder Beschleunigungsdaten oder Drehratendaten empfangen und auswerten.

Wie aus Fig. 1 und 2 weiter ersichtlich ist, umfassen die einzelnen Sensoreinheiten 10 jeweils ein Sensorelement 12, einen Sensoroszillator 14, welcher ein Sensortaktsignal STS mit einer vorgegebenen Periodendauer $T\_STS$ erzeugt und ausgibt, und eine Vorrichtung 20 zur Korrektur von mindestens einem Übertragungsparameter für eine Datenübertragung zwischen einer Sensoreinheit 10 und einem Steuergerät 30. Der mindestens eine Übertragungsparameter wird basierend auf dem Sensortaktsignal STS bestimmt. Im dargestellten Ausführungsbeispiel repräsentiert ein erster Übertragungsparameter einen Sendestartzeitpunkt $t\_NS$ und ein zweiter Übertragungsparameter repräsentiert eine Bitbreite $t\_Bit$.

Im dargestellten Ausführungsbeispiel ist die Vorrichtung 20 zur Korrektur von mindestens einem Übertragungsparameter als anwendungsspezifische integrierte Schaltung (ASIC) ausgeführt, welche mindestens eine Rechnereinheit bzw. mindestens einen Mikrocontroller umfasst und erfasste Sensorsignale verarbeitet und auswertet.

Wie aus Fig. 2 weiter ersichtlich ist, umfasst die Vorrichtung 20 zur Korrektur von mindestens einem Übertragungsparameter einen Oszillatormonitor 22, welcher das Sensortaktsignal STS und das Referenztaktsignal RTS empfängt und ein erfindungsgemäßes Verfahren zur Korrektur von mindestens einem Übertragungsparameter ausführt. Hierbei wird das Sensortaktsignal STS in einem ersten Schritt mit dem Referenztaktsignal RTS verglichen, wobei basierend auf dem Vergleich eine Abweichung $Delta\_t$ der aktuellen Periodendauer $T\_STS$ des Sensortaktsignals STS von einer Sollperiodendauer $T\_STS\_soll$ ermittelt wird, und wobei der mindestens eine Übertragungsparameter basierend auf der ermittelten Abweichung $Delta\_t$ korrigiert wird.

Das Verfahren zur Korrektur von mindestens einem Übertragungsparameter kann beispielsweise in Software oder Hardware oder in einer Mischform aus Software und Hardware in den einzelnen Sensoreinheiten 10 implementiert sein.

Im dargestellten Ausführungsbeispiel weist das Referenztaktsignal RTS eine Frequenz von 2 kHz und eine Referenzperiodendauer $T\_ref$ von 500 $\mu$s $\pm$ 1 % auf. Das Sensortaktsignal STS weist im dargestellten Ausführungsbeispiel eine Frequenz von 18 MHz und eine Sollperiodendauer $T\_STS$ soll von 0,0555 $\mu$s auf. Für die Erkennung der Abweichung $Delta\_t$ des Sensortaktsignals STS der Sensoreinheit 10 relativ zum Referenztaktsignal RTS des Steuergeräts 30 wird somit die Abweichung $Delta\_t$ gemäß Gleichung (1) berechnet.

$$\text{Delta\_t} = \text{T\_ref} - N * \text{T\_STS mit } N = \text{T\_ref} / \text{T\_STS\_soll} \quad (1)$$

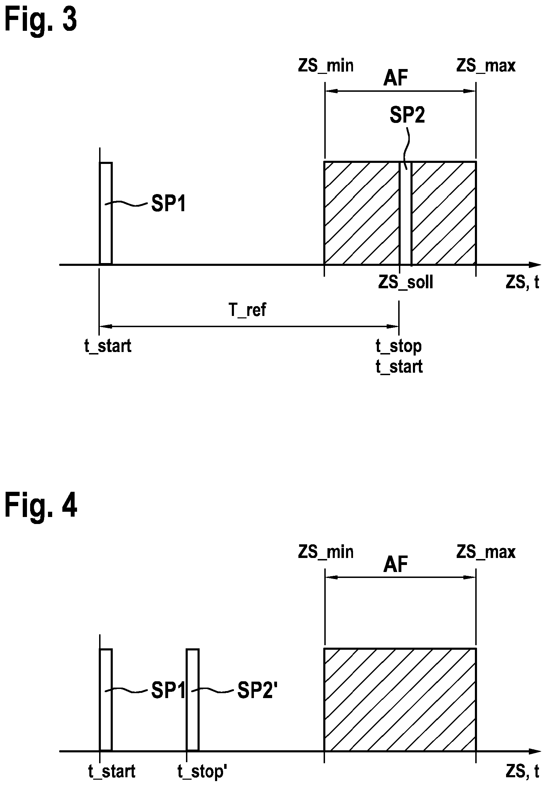

Für die oben angegebenen Werte ergibt sich für den Faktor N ein Wert von 9.000. In Abhängigkeit der Abweichung $Delta\_t$ des Sensortaktsignals STS und des Referenztaktsignal RTS erfolgt in einem weiteren Schritt eine proportionale Anpassung der auf dem PSI5 Standard basierenden Sendestartzeitpunkte $t\_NS$ und der Bitbreiten $t\_Bit$ in der jeweiligen Sensoreinheit 10 vor einer Datenübertragung. Auf diese Weise kommt es zu keiner Datenkollision auf dem PSI5 Übertragungsbus, auch wenn das Sensortaktsignal STS der Sensoreinheit 10 im dargestellten Ausführungsbeispiel um bis zu $\pm$ 10 % vom Nominalfall abweichen kann. Die typischen Toleranzen des Sensortaktsignals STS liegen über Lebensdauer bei $\pm$ 3,5 %. Die erlaubte obere Grenze für Abweichungen des Sensortaktsignals STS in der jeweiligen Sensoreinheit 10 liegt gemäß PSI5 Standard bei $\pm$ 5 %. Der Bereich für die Korrektur des mindestens einen Übertragungsparameters startet bei dem dargestellten Ausführungsbeispiel bei einer Abweichung $Delta\_t$ von $\pm$ 0 % und endet bei einer Abweichung $Delta\_t$ von ca. $\pm$ 10 %. Dies entspricht auch einem in Fig. 3 bis 5 dargestellten Akzeptanzfenster AF, in welchem die jeweilige Sensoreinheit 10 zweite Synchronisationspulse SP2 des Steuergeräts 30 als gültig akzeptiert. Die äußere Grenze von $\pm$ 10 % für die Abweichung $Delta\_t$ ergibt sich aus der gemäß PSI5 Standard erlaubten Toleranz von $\pm$ 5 % für das Sensortaktsignal STS, aus einer Toleranz von $\pm$ 1 % des Referenztaktsignals RTS und einem Sicherheitsabstand von hier $\pm$ 4 %. Der Sicherheitsabstand wurde so gewählt, dass eine Übertragung von Daten in einen Airbagalgorithmus zu keiner nennenswerten Abweichung von Auslösezeiten führt.

Die Anpassung der Sendestartzeitpunkte $t\_NS$ und der Bitbreiten $t\_Bit$ erfolgt im Rahmen der Erfindung nicht schlagartig sondern mit Hilfe einer langsamen Regelfunktion. Eine solche langsame Regelfunktion bietet den Vorteil, dass die Anpassung der Sendestartzeitpunkte $t\_NS$ und der Bitbreiten $t\_Bit$ langsam und nicht sprungartig erfolgt. Die Datenübertragung wird somit stabiler. Um ein Einschwingen der Regelfunktion innerhalb einer ersten Initialisierungsphase der Sensoreinheit 10 zu ermöglichen, und somit eine fehlerfreie Datenübertragung von Sensorstatusdaten schon in einer zweiten Initialisierungsphase zu gewährleisten, wird eine minimale Regelgeschwindigkeit in der ersten Initialisierungsphase auf mindestens 60 % / s eingestellt. Hierbei dauert die erste Initialisierungsphase mindestens 50 ms. Das Steuergerät 30 startet die Übertragung des Referenztaktsignals RTS ca. 10 ms nach dem Einschalten. Für das Einschwingen des Referenztaktsignals RTS werden weitere 5 ms vorgesehen. Somit stehen in der ersten Initialisierungsphase noch 35 ms bzw. 70 Synchronisationspulse SP1, SP2 für das Einschwingen der Regelfunktion zur Verfügung. Mit einer kleinsten Regelrate von 2 % / 0,035 s ergibt sich eine Regelrate von 57,1 % / s. Mit einer maximal erlaubten Abweichung $Delta\_t$ des Sensortaktsignal STS von 5 % ergibt sich eine Regelrate von 57,1 % / s * 1,05 % = 60,0 % / s. Nach der ersten Initialisierungsphase wird die Regelfunktion für die Sendestartzeitpunkte $t\_NS$ und Bitbreiten $t\_Bit$ langsamer betrieben. Hierzu können verschiedene Regelraten RR in einem nicht näher dargestellten Speicher abgelegt werden. Für das dargestellte Ausführungsbeispiel sind beispielsweise die folgenden Werte für die Regelrate RR abgespeichert: $\pm$ 0,0625 % / s, $\pm$ 0,03215 % / s, $\pm$ 0,125 % / s, $\pm$ 0,25 % / s, $\pm$ 0,5 % / s, $\pm$ 1 % / s, $\pm$ 2 %/s, $\pm$ 4 % / s.

Die Anpassung des mindestens einen Übertragungsparameters bzw. der Sendestartzeitpunkte $t\_NS$ und der Bitbreiten $t\_Bit$ an die ermittelte Abweichung $Delta\_t$ erfolgt mit Hilfe eines Korrekturfaktors KF in einstellbaren Stufen. Das bedeutet, dass der Korrekturfaktor KF sich über die Zeit in Abhängigkeit der eingestellten Regelrate RR als Stufe ergibt ($KF = \Sigma RR$). Hierbei wird der Korrekturfaktor KF um die eingestellte Regelrate RR reduziert, wenn die ermittelte Abweichung $Delta\_t$ größer als ein vorgegebener Sollwert von beispielsweise 0 ist. Ist die ermittelte Abweichung $Delta\_t$ kleiner als der vorgegebene Sollwert, dann wird der Korrekturfaktor KF um die Regelrate RR erhöht. Ist die ermittelte Abweichung $Delta\_t$ gleich dem vorgegebenen Sollwert, dann wird der Korrekturfaktor KF nicht verändert und bleibt konstant.

Der Korrekturfaktor KF wird gemäß Gleichung (2) auf den Sendestartzeitpunkt $t\_NS$ und gemäß Gleichung (3) auf die Bitbreite $t\_Bit$ angewendet.

$$\text{t\_NS,KF} = (KF * \text{t\_NS}) + \text{t\_NS} \quad (2)$$

$$t\_Bit,KF = (KF * t\_Bit) + t\_Bit \qquad (3)$$

Im dargestellten Ausführungsbeispiel umfasst die Vorrichtung 20 zur Korrektur von mindestens einem Übertragungsparameter einen Zähler 24, welcher Pulse des Sensortaktsignals STS zählt. Nachfolgend wird unter Bezugnahme auf Fig. 3 bis 5 die Funktionsweise der Vorrichtung 20 zur Korrektur von mindestens einem Übertragungsparameter aus Fig. 2 beschrieben. Der Oszillatormonitor 22 startet den Zähler 24 an einem Startzeitpunkt t_start, t_start", an welchem der Oszillatormonitor 22 einen ersten Synchronisationspuls SP1 des Referenztaktsignals RTS empfängt. Der Oszillatormonitor 22 hält den Zähler 24 an einem Stoppzeitpunkt t_stop, t_stop', t_stop" an, an welchem der Oszillatormonitor 22 einen nachfolgenden zweiten Synchronisationspuls SP2, SP2', SP2" empfängt. Der Oszillatormonitor 22 liest dann einen Zählerstand ZS des Zählers 24 aus und vergleicht diesen mit einem Sollzählerstand ZS_soll, welcher aus dem Verhältnis von Referenzperiodendauer T_ref zu Sollperiodendauer T_STS_soll des Sensortaktsignals STS berechnet ist. Mit den o.g. Werten ergibt sich ein Sollzählerstand ZS_soll von 9.000. Somit kann der Oszillatormonitor 22 basierend auf einem Vergleich des Sollzählerstands ZS_soll und des aktuellen Zählerstands ZS die Abweichung Delta_t der aktuellen Periodendauer T_STS des Sensortaktsignals STS von der Sollperiodendauer T_STS_soll gemäß Gleichung (4) ermitteln.

$$Delta\_t = (ZS\_soll - ZS) * T\_STS\_soll \qquad (4)$$

Basierend auf dem vorgegebenen Toleranzbereich von $\pm 10\%$ für die Abweichung Delta_t berechnet der Oszillatormonitor 22 das Akzeptanzfenster AF, welches nach unten durch einen ersten Zählerstand ZS_min von hier 8.100 und nach oben durch einen zweiten Zählerstand ZS_max von hier 9.900 begrenzt ist. Der Oszillatormonitor 22 korrigiert den mindestens einen Übertragungsparameter basierend auf der ermittelten Abweichung Delta_t, wenn der ausgelesene aktuelle Zählerstand ZS innerhalb des Akzeptanzfensters AF liegt.

Wie aus Fig. 3 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop empfängt der Oszillatormonitor 22 den zweiten Synchronisationspuls SP2 innerhalb des Akzeptanzfensters AF. Das bedeutet, dass der ausgelesene aktuelle Zählerstand ZS zwischen dem ersten Zählerstand ZS_min von hier 8.100 und dem zweiten Zählerstand ZS_max von hier 9.900 liegt. Daher interpretiert der Oszillatormonitor 22 die beiden Synchronisationspulse SP1, SP2 als gültiges Synchronisationspulspaar. Daher passt der Oszillatormonitor 22 den Korrekturfaktor KF an die ermittelte Abweichung Delta_t an und korrigiert den mindestens einen Übertragungsparameter mit dem angepassten Korrekturfaktor KF. Zudem interpretiert der Oszillatormonitor 22 den zweiten Synchronisationspuls SP2 als neuen ersten Synchronisationspuls SP1 und startet den Zähler 24 neu, wenn der ausgelesene aktuelle Zählerstand ZS innerhalb des Akzeptanzfensters AF liegt. Da Fig. 3 einen optimalen Zustand mit einer Abweichung Delta_t von 0 zeigt, entspricht der ausgelesene aktuelle Zählerstand ZS dem Sollzählerstand ZS_soll, so dass der verwendete Korrekturfaktor KF konstant bleibt.

Wie aus Fig. 4 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop' empfängt der Oszillatormonitor 22 den zweiten Synchronisationspuls SP2' außerhalb des Akzeptanzfensters AF. Bei der Darstellung gemäß Fig. 4 liegt der ausgelesene Zählerstand ZS unter dem ersten Zählerstand ZS_min von hier 8.100. Daher interpretiert der Oszillatormonitor 22 den zweiten Synchronisationspuls SP2' als Störimpuls und die beiden Synchronisationspulse SP1, SP2' als ungültiges Synchronisationspulspaar. Da es sich in diesem Fall um einen Störimpuls handelt, wird dieser vom Oszillatormonitor 22 ignoriert und es erfolgt keine Anpassung des Korrekturfaktors KF und auch keine Korrektur des mindestens einen Übertragungsparameters. Zudem werden nach dem zweiten Synchronisationspuls SP2' keine Daten an das Steuergerät 30 übertragen.

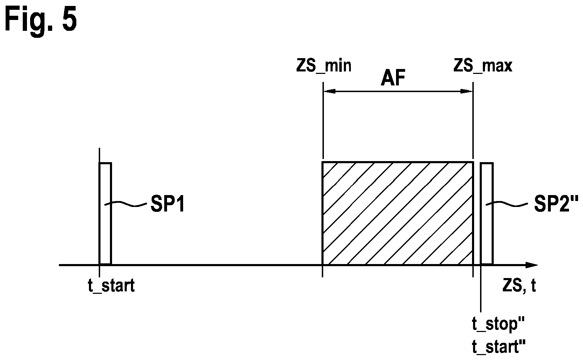

Wie aus Fig. 5 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop" empfängt der Oszillatormonitor 22 den zweiten Synchronisationspuls SP2" außerhalb des Akzeptanzfensters AF. Bei der Darstellung gemäß Fig. 5 liegt der ausgelesene Zählerstand ZS über dem zweiten Zählerstand ZS_max von hier 9.900. In diesem Fall wird der empfangene zweite Synchronisationspuls SP2" vom Oszillatormonitor 22 akzeptiert. Der Oszillatormonitor 22 interpretiert jedoch den zweiten Synchronisationspuls SP2" als neuen ersten Synchronisationspuls SP1. Das bedeutet der zweite Synchronisationspuls SP2" dient als neuer Startzeitpunkt t_start für die Referenztaktmessung bzw. für den Zähler 24 in der Sensoreinheit 10. Der bereits vorhandene Korrekturfaktor KF bleibt jedoch unverändert und der Oszillatormonitor 22 führt eine Korrektur des mindestens einen Übertragungsparameters mit dem bereits vorhandenen Korrekturfaktor KF durch.

Ausführungsformen der vorliegenden Erfindung bieten den weiteren Vorteil, dass die Datenübertragung noch robuster gegenüber EMV Störungen von außen ist. Schließlich soll im Fall einer EMV Störung keine Anpassung des Korrekturfaktors durchgeführt werden.

**EP 3 692 680 B1**

**Patentansprüche**

1.  Verfahren zur Korrektur von mindestens einem Übertragungsparameter für eine Datenübertragung zwischen einer Sensoreinheit (10) und einem Steuergerät (30), wobei von einem Sensoroszillator (14) ein Sensortaktsignal (STS) mit einer vorgegebenen Periodendauer (T_STS) erzeugt wird, wobei der mindestens eine Übertragungsparameter basierend auf dem Sensortaktsignal (STS) bestimmt wird, wobei ein von einem Referenzoszillator (32) mit einer vorgegebenen Referenzperiodendauer (T_ref) erzeugtes Referenztaktsignal (RTS) empfangen wird, wobei das Sensortaktsignal (STS) mit dem Referenztaktsignal (RTS) verglichen wird, wobei basierend auf dem Vergleich eine Abweichung (Delta_t) der aktuellen Periodendauer (T_STS) des Sensortaktsignals (STS) von einer Sollperiodendauer (T_STS_soll) ermittelt wird, wobei der mindestens eine Übertragungsparameter basierend auf der ermittelten Abweichung (Delta_t) korrigiert wird, **dadurch gekennzeichnet, dass** in Abhängigkeit von der Abweichung (Delta_t) ein Korrekturfaktor (KF) berechnet wird, welcher auf den mindestens einen Übertragungsparameter angewendet wird, wobei der Korrekturfaktor (KF) um eine eingestellte Stufe reduziert wird, wenn die Abweichung (Delta_t) größer als ein vorgegebener Schwellwert ist, oder um die eingestellte Stufe erhöht wird, wenn die Abweichung (Delta_t) kleiner als der vorgegebenen Schwellwert ist, oder konstant bleibt, wenn die Abweichung (Delta_t) gleich dem vorgegebenen Schwellwert ist.

2.  Verfahren nach Anspruch 1, **dadurch gekennzeichnet, dass** der mindestens eine Übertragungsparameter einen Sendestartzeitpunkt (t_NS) und/oder eine Bitbreite (t_Bit) repräsentiert.

3.  Vorrichtung (20) zur Korrektur von mindestens einem Übertragungsparameter für eine Datenübertragung zwischen einer Sensoreinheit (10) und einem Steuergerät (30), wobei ein Sensoroszillator (14) ein Sensortaktsignal (STS) mit einer vorgegebenen Periodendauer (T_STS) erzeugt und ausgibt, wobei der mindestens eine Übertragungsparameter basierend auf dem Sensortaktsignal (STS) bestimmt wird, und wobei ein Referenzoszillator (32) ein Referenztaktsignal (RTS) mit einer vorgegebenen Referenzperiodendauer (T_ref) erzeugt und ausgibt, wobei ein Oszillatormonitor (22) das Sensortaktsignal (STS) und das Referenztaktsignal (RTS) empfängt und miteinander vergleicht und basierend auf dem Vergleich eine Abweichung (Delta_t) der aktuellen Periodendauer (T_STS) von einer Sollperiodendauer (T_STS_soll) ermittelt und basierend auf der ermittelten Abweichung (Delta_t) den mindestens einen Übertragungsparameter korrigiert, **dadurch gekennzeichnet, dass** der Oszillatormonitor (22) in Abhängigkeit von der Abweichung (Delta_t) einen Korrekturfaktor (KF) berechnet und auf den mindestens einen Übertragungsparameter angewendet, wobei der Oszillatormonitor (22) den Korrekturfaktor (KF) um eine eingestellte Stufe reduziert, wenn die Abweichung (Delta_t) größer als ein vorgegebener Schwellwert ist, oder um die eingestellte Stufe erhöht, wenn die Abweichung (Delta_t) kleiner als der vorgegebenen Schwellwert ist, oder konstant lässt, wenn die Abweichung (Delta_t) gleich dem vorgegebenen Schwellwert ist.

4.  Vorrichtung (20) nach Anspruch 3, **gekennzeichnet durch** einen Zähler (24), welcher Pulse des Sensortaktsignals (STS) zählt, wobei der Oszillatormonitor (22) den Zähler (24) an einem Startzeitpunkt (t_start, t_start") startet, an welchem der Oszillatormonitor (22) einen ersten Synchronisationspuls (SP1) des Referenztaktsignals (RTS) empfängt, und den Zähler (24) an einem Stoppzeitpunkt (t_stop, t_stop', t_stop") anhält, an welchem der Oszillatormonitor (22) einen nachfolgenden zweiten Synchronisationspuls (SP2, SP2', SP2") empfängt.

5.  Vorrichtung (20) nach Anspruch 4, **dadurch gekennzeichnet, dass** der Oszillatormonitor (22) einen Zählerstand (ZS) des Zählers (24) ausliest und mit einem Sollzählerstand (ZS_soll) vergleicht, welcher aus dem Verhältnis von Referenzperiodendauer (T_ref) zu Sollperiodendauer (T_STS_soll) des Sensortaktsignals (STS) berechnet ist.

6.  Vorrichtung (20) nach Anspruch 5, **dadurch gekennzeichnet, dass** der Oszillatormonitor (22) basierend auf dem Vergleich eine Abweichung (Delta_t) der aktuellen Periodendauer (T_STS) des Sensortaktsignals (STS) von einer Sollperiodendauer (T_STS_soll) ermittelt.

7.  Vorrichtung (20) nach Anspruch 6, **dadurch gekennzeichnet, dass** der Oszillatormonitor (22) basierend auf einem vorgegebenen Toleranzbereich für die Abweichung (Delta_t) ein Akzeptanzfenster (AF) berechnet, welches nach unten durch einen ersten Zählerstand (ZS_min) und nach oben durch einen zweiten Zählerstand (ZS_max) begrenzt ist.

8.  Vorrichtung (20) nach Anspruch 7, **dadurch gekennzeichnet, dass** der Oszillatormonitor (22) den Korrekturfaktor (KF) an die ermittelte Abweichung (Delta_t) anpasst und den mindestens einen Übertragungsparameter mit dem angepassten Korrekturfaktor (KF) korrigiert, wenn der ausgelesene aktuelle Zählerstand (ZS) innerhalb des Akzeptanzfensters (AF) liegt.

9

9. Vorrichtung (20) nach Anspruch 8, **dadurch gekennzeichnet, dass** der Oszillatormonitor (22) den zweiten Synchronisationspuls (SP2) als neuen ersten Synchronisationspuls (SP1) interpretiert und den Zähler (24) neu startet, wenn der ausgelesene aktuelle Zählerstand (ZS) innerhalb des Akzeptanzfensters (AF) liegt.

10. Vorrichtung (20) nach einem der Ansprüche 7 bis 9, **dadurch gekennzeichnet, dass** der Oszillatormonitor (22) den zweiten Synchronisationspuls (SP2') als Störimpuls interpretiert, wenn der korrespondierende ausgelesene aktuelle Zählerstand (ZS) kleiner als der erste Zählerstand (ZS_min) ist.

11. Vorrichtung (20) nach Anspruch 10, **dadurch gekennzeichnet, dass** der Oszillatormonitor (22) den als Störimpuls interpretierten zweiten Synchronisationspuls (SP2') ignoriert und keine Anpassung des Korrekturfaktors (KF) und keine Korrektur des mindestens einen Übertragungsparameters durchführt.

12. Vorrichtung (20) nach einem der Ansprüche 7 bis 11, **dadurch gekennzeichnet, dass** der Oszillatormonitor (22) den zweiten Synchronisationspuls (SP2") als neuen ersten Synchronisationspuls (SP1) interpretiert, wenn der korrespondierende ausgelesene aktuelle Zählerstand (ZS) größer als der zweite Zählerstand (ZS_max) ist.

13. Vorrichtung (20) nach Anspruch 12, **dadurch gekennzeichnet, dass** der Oszillatormonitor (22) in Reaktion auf den als neuer erster Synchronisationspuls (SP1) interpretierten zweiten Synchronisationspuls (SP2") den Zähler (24) neu startet und eine Korrektur des mindestens einen Übertragungsparameters mit einem bereits vorhandenen Korrekturfaktor (KF) durchführt.

## Claims

1. Method for correcting at least one transmission parameter for data transmission between a sensor unit (10) and a control unit (30), wherein a sensor clock signal (STS) is generated with a predefined period length (T_STS) by a sensor oscillator (14), wherein the at least one transmission parameter is determined on the basis of the sensor clock signal (STS), wherein a reference clock signal (RTS) which is generated by a reference oscillator (32) with a predefined reference period length (T_ref) is received, wherein the sensor clock signal (STS) is compared with the reference clock signal (RTS), wherein a deviation (Delta _t) of the current period length (T_STS) of the sensor clock signal (STS) from a setpoint period length (T_STS_soll) is determined on the basis of the comparison, wherein the at least one transmission parameter is corrected on the basis of the determined deviation (Delta_t), **characterized in that** a correction factor (KF), which is applied to the at least one transmission parameter, is calculated as a function of the deviation (Delta _t), wherein the correction factor (KF) is reduced by a set stage if the deviation (Delta_t) is greater than a predefined threshold value, or is increased by the set stage if the deviation (Delta_t) is smaller than the predefined threshold value, or remains constant if the deviation (Delta_t) is equal to the predefined threshold value.

2. Method according to Claim 1, **characterized in that** the at least one transmission parameter represents a transmission start time (t_NS) and/or a bit width (t_Bit).

3. Device (20) for correcting at least one transmission parameter for data transmission between a sensor unit (10) and a control unit (30), wherein a sensor oscillator (14) generates and outputs a sensor clock signal (STS) with a predefined period length (T_STS), wherein the at least one transmission parameter is determined on the basis of the sensor clock signal (STS), and wherein a reference oscillator (32) generates and outputs a reference clock signal (RTS) with a predefined reference period length (T_ref), wherein an oscillator monitor (22) receives the sensor clock signal (STS) and the reference clock signal (RTS) and compares them with one another and determines a deviation (Delta _t) of the current period length (T_STS) from a setpoint period length (T_STS_soll) on the basis of the comparison and corrects the at least one transmission parameter on the basis of the determined deviation (Delta _t), **characterized in that** the oscillation monitor (22) calculates a correction factor (KF) as a function of the deviation (Delta _t) and applies it to the at least one transmission parameter, wherein the oscillation monitor (22) reduces the correction factor (KF) by a set stage if the deviation (Delta_t) is greater than a predefined threshold value, or increases it by the set stage if the deviation (Delta_t) is smaller than the predefined threshold value, or keeps it constant if the deviation (Delta_t) is equal to the predefined threshold value.

4. Device (20) according to Claim 3, **characterized by** a counter (24) which counts pulses of the sensor clock signal (STS), wherein the oscillator monitor (22) starts the counter (24) at a start time (t_start, t_start") at which the oscillator monitor (22) receives a first synchronization pulse (SP1) of the reference clock signal (RTS) and stops the counter (24) at a stop time (t_stop, t_stop', t_stop") at which the oscillator monitor (22) receives a subsequent second synchronization pulse (SP2, SP2', SP2").

5. Device (20) according to Claim 4, **characterized in that** the oscillator monitor (22) reads out a counter reading (ZS) of the counter (24) and compares it with a setpoint counter reading (ZS_soll) which is calculated from the ratio of the reference period length (T_ref) to the setpoint period length (T_STS_soll) of the sensor clock signal (STS).

6. Device (20) according to Claim 5, **characterized in that**, on the basis of the comparison, the oscillator monitor (22) determines a deviation (Delta _t) of the current period length (T_STS) of the sensor clock signal (STS) from a setpoint period length (T_STS_soll).

7. Device (20) according to Claim 6, **characterized in that**, on the basis of a predefined tolerance range for the deviation (Delta _t), the oscillator monitor (22) calculates an acceptance window (AF) which is limited downwards by a first counter reading (ZS_min) and upwards by a second counter reading (ZS_max).

8. Device (20) according to Claim 7, **characterized in that** the oscillator monitor (22) adapts the correction factor (KF) to the determined deviation (Delta_t) and corrects the at least one transmission parameter with the adapted correction factor (KF) if the current read-out counter reading (ZS) lies within the acceptance window (AF) .

9. Device (20) according to Claim 8, **characterized in that** the oscillator monitor (22) interprets the second synchronization pulse (SP2) as a new first synchronization pulse (SP1) and restarts the counter (24) if the current read-out counter reading (ZS) lies within the acceptance window (AF).

10. Device (20) according to one of Claims 7 to 9, **characterized in that** the oscillator monitor (22) interprets the second synchronization pulse (SP2') as an interference pulse if the corresponding current read-out counter reading (ZS) is lower than the first counter reading (ZS_min).

11. Device (20) according to Claim 10, **characterized in that** the oscillator monitor (22) ignores the second synchronization pulse (SP2') which is interpreted as an interference pulse, and does not carry out any adaptation of the correction factor (KF) and does not carry out any correction of the at least one transmission parameter.

12. Device (20) according to one of Claims 7 to 11, **characterized in that** the oscillator monitor (22) interprets the second synchronization pulse (SP2") as a new first synchronization pulse (SP1) if the corresponding current read-out counter reading (ZS) is higher than the second counter reading (ZS_max).

13. Device (20) according to Claim 12, **characterized in that**, in reaction to the second synchronization pulse (SP2") which is interpreted as a new first synchronization pulse (SP1), the oscillator monitor (22) restarts the counter (24) and carries out a correction of the at least one transmission parameter with an already existing correction factor (KF).

**Revendications**

1. Procédé de correction d'au moins un paramètre de transmission pour une transmission de données entre une unité de détection (10) et un contrôleur (30), un signal d'horloge de capteur (STS) ayant une durée de période (T_STS) prédéfinie étant généré par un oscillateur de capteur (14), l'au moins un paramètre de transmission étant déterminé sur la base du signal d'horloge de capteur (STS), un signal d'horloge de référence (RTS) généré par un oscillateur de référence (32) avec une durée de période (T_ref) prédéfinie étant reçu, le signal d'horloge de capteur (STS) étant comparé au signal d'horloge de référence (RTS), un écart (Delta_t) entre la durée de période (T_STS) actuelle du signal d'horloge de capteur (STS) et une durée de période de consigne (T_STS_soll) étant identifié sur la base de la comparaison, l'au moins un paramètre de transmission étant corrigé sur la base de l'écart (Delta_t) identifié, **caractérisé en ce qu'**un facteur de correction (KF) est calculé en fonction de l'écart (Delta_t), lequel est appliqué à l'au moins un paramètre de transmission, le facteur de correction (KF) étant réduit d'un niveau réglé lorsque l'écart (Delta_t) est supérieur à une valeur de seuil prédéfinie, ou étant augmenté du niveau réglé lorsque l'écart (Delta_t) est inférieur à la valeur de seuil prédéfinie, ou restant constant lorsque l'écart (Delta_t) est égal à la valeur de seuil prédéfinie.

2. Procédé selon la revendication 1, **caractérisé en ce que** l'au moins un paramètre de transmission représente un instant de début d'émission (t_NS) et/ou une largeur de bit (t_Bit).

3. Dispositif (20) de correction d'au moins un paramètre de transmission pour une transmission de données entre une unité de détection (10) et un contrôleur (30), un oscillateur de capteur (14) générant et délivrant un signal d'horloge de capteur (STS) ayant une durée de période (T_STS) prédéfinie, l'au moins un paramètre de transmission étant déterminé sur la base du signal d'horloge de capteur (STS), un oscillateur de référence (32) générant et délivrant un signal d'horloge de référence (RTS) ayant une durée de période (T_ref) prédéfinie, un moniteur d'oscillateur (22) recevant le signal d'horloge de capteur (STS) et le signal d'horloge de référence (RTS) et les comparant entre eux et un écart (Delta_t) entre la durée de période (T_STS) et une durée de période de consigne (T_STS_soll) étant identifié sur la base de la comparaison et l'au moins un paramètre de transmission étant corrigé sur la base de l'écart (Delta_t) identifié, **caractérisé en ce que** le moniteur d'oscillateur (22) calcule un facteur de correction (KF) en fonction de l'écart (Delta_t) et l'applique à l'au moins un paramètre de transmission, le moniteur d'oscillateur (22) réduisant le facteur de correction (KF) d'un niveau réglé lorsque l'écart (Delta _t) est supérieur à une valeur de seuil prédéfinie, ou l'augmentant du niveau réglé lorsque l'écart (Delta_t) est inférieur à la valeur de seuil prédéfinie, ou le laissant constant lorsque l'écart (Delta_t) est égal à la valeur de seuil prédéfinie.

4. Dispositif (20) selon la revendication 3, **caractérisé par** un compteur (24) qui compte des impulsions du signal d'horloge de capteur (STS), le moniteur d'oscillateur (22) démarrant le compteur (24) à un instant de démarrage (t_start, t_start"), auquel le moniteur d'oscillateur (22) reçoit une première impulsion de synchronisation (SP1) du signal d'horloge de référence (RTS), et arrêtant le compteur (24) à un instant d'arrêt (t_stop, t_stop', t_stop") auquel le moniteur d'oscillateur (22) reçoit une deuxième impulsion de synchronisation (SP2, SP2', SP2") suivante.

5. Dispositif (20) selon la revendication 4, **caractérisé en ce que** le moniteur d'oscillateur (22) lit une position de compteur (ZS) du compteur (24) et la compare avec une position de compteur de consigne (ZS_soll) qui est calculée à partir du rapport entre la durée de période de référence (T_ref) et la durée de période de consigne (T_STS_soll) du signal d'horloge de capteur (STS).

6. Dispositif (20) selon la revendication 5, **caractérisé en ce que** le moniteur d'oscillateur (22) identifie, sur la base de la comparaison, un écart (Delta _t) entre la durée de période actuelle (T_STS) du signal d'horloge de capteur (STS) et une durée de période de consigne (T_STS_soll).

7. Dispositif (20) selon la revendication 6, **caractérisé en ce que** le moniteur d'oscillateur (22) calcule, sur la base d'une plage de tolérance prédéfinie pour l'écart (Delta_t), une fenêtre d'acceptation (AF) qui est limitée vers le bas par une première position de compteur (ZS_min) et vers le haut par une deuxième position de compteur (ZS_max).

8. Dispositif (20) selon la revendication 7, **caractérisé en ce que** le moniteur d'oscillateur (22) adapte le facteur de correction (KF) à l'écart déterminé (Delta_t) et corrige l'au moins un paramètre de transmission avec le facteur de correction (KF) adapté lorsque la position de compteur (ZS) actuellement lue se situe à l'intérieur de la fenêtre d'acceptation (AF).

9. Dispositif (20) selon la revendication 8, **caractérisé en ce que** le moniteur d'oscillateur (22) interprète la deuxième impulsion de synchronisation (SP2) comme une nouvelle première impulsion de synchronisation (SP1) et redémarre le compteur (24) si la position de compteur (ZS) actuellement lue est située à l'intérieur de la fenêtre d'acceptation (AF).

10. Dispositif (20) selon l'une des revendications 7 à 9, **caractérisé en ce que** le moniteur d'oscillateur (22) interprète la deuxième impulsion de synchronisation (SP2') comme une impulsion parasite si la position de compteur (ZS) actuellement lue correspondante est inférieure à la première position de compteur (ZS_min).

11. Dispositif (20) selon la revendication 10, **caractérisé en ce que** le moniteur d'oscillateur (22) ignore la deuxième impulsion de synchronisation (SP2') interprétée comme une impulsion parasite et n'effectue aucune adaptation du facteur de correction (KF) et aucune correction de l'au moins un paramètre de transmission.

12. Dispositif (20) selon l'une des revendications 7 à 11, **caractérisé en ce que** le moniteur d'oscillateur (22) interprète la deuxième impulsion de synchronisation (SP2") comme une nouvelle première impulsion de synchronisation (SP1) si la position de compteur (ZS) actuellement lue correspondante est supérieure à la deuxième position de compteur (ZS_max).

13. Dispositif (20) selon la revendication 12, **caractérisé en ce que** le moniteur d'oscillateur (22), en réaction à l'interprétation de la deuxième impulsion de synchronisation (SP2") comme une nouvelle première impulsion de synchronisation (SP1), redémarre le compteur (24) et effectue une correction de l'au moins un paramètre de transmission avec un facteur de correction (KF) déjà présent.

**Fig. 1**

**Fig. 2**

## Fig. 3

## Fig. 4

## Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0306059 A2
- US 20110026572 A

- DE 102012203664 A1